## Europäisches Patentamt
## European Patent Office
## Office européen des brevets

(19)

(11) Numéro de publication: **0 126 110**
**B1**

(12)

# FASCICULE DE BREVET EUROPÉEN

(45) Date de publication du fascicule du brevet: **14.01.87**

(51) Int. Cl.⁴: **H 01 L 35/08**, G 01 K 17/00

(21) Numéro de dépôt: **83903546.6**

(22) Date de dépôt: **17.11.83**

(86) Numéro de dépôt international: **PCT/FR 83/00225**

(87) Numéro de publication internationale: **WO 84/02037 (24.05.84 Gazette 84/13)**

(54) **FLUXMETRE THERMIQUE A THERMOCOUPLES.**

(30) Priorité: **18.11.82 FR 8219336**

(43) Date de publication de la demande: **28.11.84 Bulletin 84/48**

(45) Mention de la délivrance du brevet: **14.01.87 Bulletin 87/3**

(84) Etats contractants désignés: **AT BE CH DE FR GB LI LU NL SE**

(56) Documents cité: **EP-A-0 030 499** **US-A-4 029 521** **US-A-4 197 738**

(73) Titulaire: **ANVAR Agence Nationale de Valorisation de la Recherche, 43, rue Caumartin, F-75436 Paris Cédex 09 (FR)**

(72) Inventeur: **THERY, Pierre, 45, rue de Lille, F-59650 Villeneuve d'Ascq (FR)**
Inventeur: **RAVALITERA, Guy, 2/1 Résidence du Mt Liebaut rue Coty, F-62400 Bethune (FR)**
Inventeur: **CORNET, Michel, I.U.T. rue du Moulin à Tabac, F-62408 Bethune (FR)**

(74) Mandataire: **Lecca, Jean, CABINET PLASSERAUD 84, rue d'Amsterdam, F-75009 Paris (FR)**

LIBER, STOCKHOLM 1987

## Description

La présente invention concerne un fluxmètre thermique, c'est-à-dire un dispositif destiné à mesurer un flux thermique résultant d'un gradient de température, et plus particulièrement un fluxmètre thermique comportant plusieurs dizaines et de préférence plusieurs centaines de thermocouples élémentaires disposés en série.

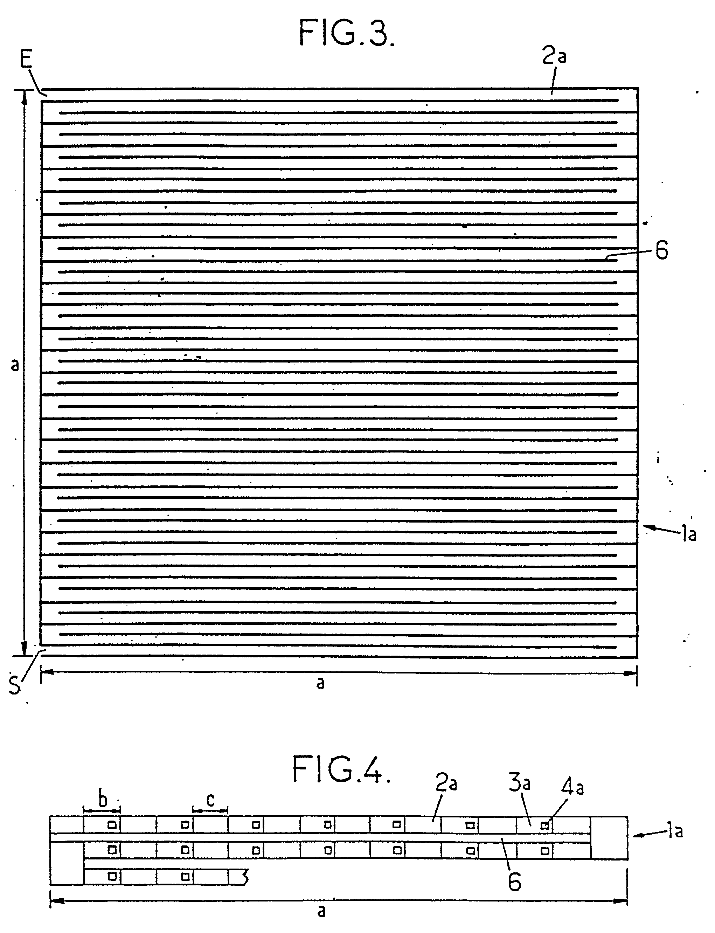

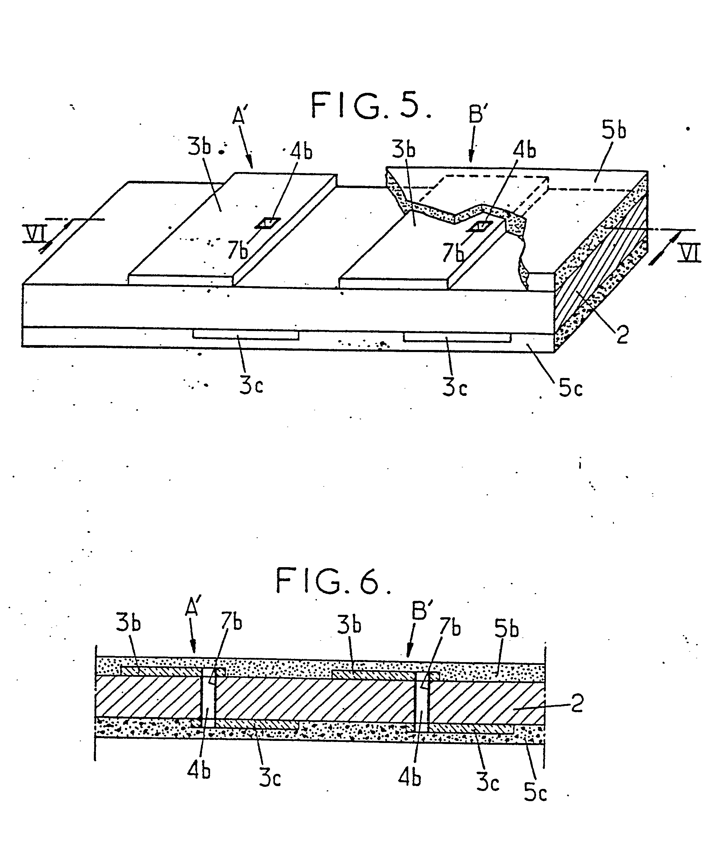

On a décrit dans la demande de brevet européenne EP-A- 0 030 499, déposée le 1er décembre 1980 par la demanderesse et publiée le 17 juin 1981, un fluxmètre thermique à nombreux thermocouples, notamment avec référence aux figures 3 à 5 de cette demande européenne, comportant, suivant un trajet méandriforme (figure 3), une succession de thermocouples élémentaires connectés en série (figures 4 et 5); ce fluxmètre comprend une plaque en une matière plastique revêtue par une bande ou couche mince méandriforme en une première substance conductrice ou semi-conductrice, notamment en constantan, cette bande ou couche mince étant à son tour revêtue d'une succession de zones, séparées l'une de l'autre, de dépôt électrolytique en une seconde matière conductrice ou semi-conductrice présentant un pouvoir thermoélectrique différent de celui de la première matière conductrice ou semi-conductrice, notamment en cuivre. Dans le mode de réalisation de la figure 4 de cette demande européenne, lesdites zones avaient une forme dissymétrique par rapport à une direction transversale (forme en queue d'aronde), tandis que dans le mode de réalisation de la figure 5 de cette demande le dispositif comportait une succession de revêtements de résine chevauchant chacun une portion d'une desdites zones et une portion adjacente de la bande ou couche non revêtue de dépôt de ladite seconde matière. On réalisait ainsi également une dissymétrie par rapport à une direction transversale.

L'ensemble des cellules élémentaires ou thermocouples était connecté en série par la bande ou couche en la première matière, qui était continue. C'est la dissymétrie par rapport à une direction transversale qui permettait d'engendrer une force électromotrice fonction de la différence de température à laquelle était soumise chaque cellule élémentaire, la première et la seconde matières précitées ayant des propriétés thermoélectriques différentes.

On connaît par ailleurs un fluxmètre thermique selon le brevet des US-A- 4.197.738 de Monsieur Degenne, déposé le 10 juillet 1978 et délivré le 15 avril 1980. Ce brevet décrit un fluxmètre thermique constitué par des thermocouples connectés en série et comprenant une plaque relativement épaisse en une matière isolante percée de deux séries de canaux transversaux traversant toute l'épaisseur de la plaque; sur chaque face de cette plaque est disposée une série de revêtements en une première matière conductrice séparés les uns des autres par d'étroites bandes de plaque non revêtues de cette matière conductrice; en outre les canaux sont revêtus intérieurement, les canaux de la première série étant revêtus de ladite première matière conductrice et les canaux de la seconde série étant revêtus d'une seconde matière conductrice présentant des pouvoirs thermoélectriques différents; enfin des rondelles en la seconde matière conductrice entourent les bords supérieurs et inférieurs des canaux de la seconde série de canaux. La première matière peut être le cuivre et la seconde matière du nickel.

On notera que ni le revêtement en la première matière conductrice, ni le revêtement en la seconde matière conductrice n'est continu mais forme un ensemble de surfaces (sur les faces de la plaque et sur le pourtour intérieur des canaux) discontinues.

Enfin le brevet US-A- 4.029.521 aux noms de Korn et Shtrickman déposé le 3 octobre 1975 et délivré le 14 juin 1977 décrit un détecteur thermoélectrique comportant un support inerte, une bande continue en une première matière, par exemple méandriforme, et une succession de dépôts discrets, en une seconde matière, disposés sur cette bande, les pouvoirs thermoélectriques de ces deux matières étant différents; des zones chaudes et froides sont réalisées au moyen d'éléments réflecteurs E, d'éléments G absorbant les radiations et d'éléments conducteurs F formant puits de chaleur, ces éléments E, G et F créant des zones chaudes et froides aux extrémités des dépôts discrets B disposés sur la bande continue A.

Aucun canal ne traverse les dépôts B et/ou la bande A.

Contrairement aux techniques antérieures, la présente invention a pour objet un fluxmètre thermique à nombreux thermocouples comportant une couche mince continue en une première matière conductrice ou semi-conductrice recouverte sur au moins une de ses faces par une succession de zones, séparées l'une de l'autre, constituées par des dépôts très minces d'une seconde matière conductrice ou semiconductrice ayant un pouvoir thermoélectrique différent de celui de la première matière, caractérisé par le fait qu'au moins un canal traverse de part en part au moins la plupart desdites zones et la couche mince sous-jacente, ces canaux étant décalés dans le même sens par rapport au centre de chaque zone traversée.

De préférence lesdits canaux sont revêtus intérieurement d'un dépôt de la seconde matière.

Avantageusement ladite couche mince continue a la forme d'une bande qui est de préférence méandriforme, en étant repliée pour former une structure rectangulaire ou carrée.

Dans un premier mode de réalisation, la couche mince est déposée sur un substrat en matière isolante et elle est revêtue sur une seule face, à savoir celle opposée à la face fixée sur le substrat, de zones de dépôt très minces.

Dans un second mode de réalisation, la couche mince est revêtue sur ses deux faces de zones de dépôt très minces, les zones d'une des faces chevauchant partiellement les zones de l'autre face de part et d'autre de la couche mince, et chaque canal, qui traverse tant la couche mince que les portions chevauchantes desdeux dépôts très minces de part et d'autre de la couche mince, est décalé, par rapport au centre de chacun des deux dépôts, en sens inverses au-dessus et au-dessous de la couche.

De préférence la première matière est le constantan et la seconde matière le cuivre.

Avantageusement la succession de zones de dépôt très minces et la portion non revêtue de la couche mince ou de la ou des faces recouvertes sont revêtues de couches de résine.

Chaque canal peut déboucher soit à l'intérieur d'une zone de dépôt, soit à cheval sur une telle zone et une portion non revêtue de la couche mince.

Le fluxmètre thermique selon l'invention peut comprendre plusieurs centaines de thermocouples élémentaires, à savoir autant qu'il y a de zones sur une face ou chacune des faces de la couche mince.

On notera qu'un dispositif selon l'invention se distingue essentiellement des fluxmètres thermiques selon la demande EP-A- 0 030 499 et le brevet US-A- 4.029.521 par la présence de canaux, non prévus dans ces documents, et du fluxmètre selon le brevet US-A- 4.197.738 par le fait que la couche mince est continue, alors que dans ce brevet US aucun des revêtements supérieur ou inférieur n'est continu.

L'invention pourra, de toute façon, être bien comprise à l'aide du complément de description qui suit, ainsi que des dessins ci-annexés, lesquels complément et dessins sont, bien entendu, donnés surtout à titre d'indication.

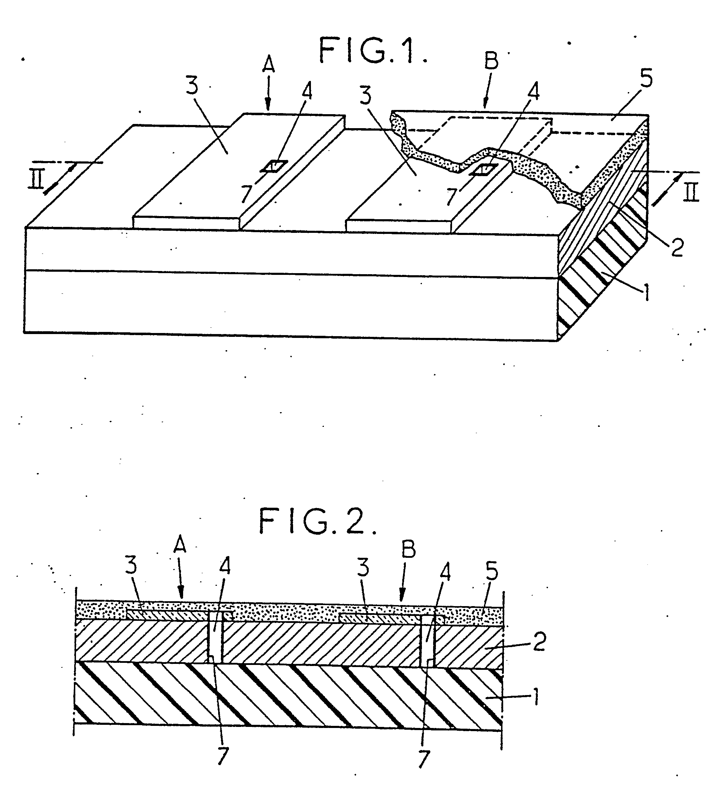

Les figures 1 et 2 représentent, respectivement en perspective cavalière avec arrachement partiel de la couche supérieure de résine protectrice et en coupe partielle (par II-II de la figure 1), une portion, comportant deux cellules élémentaires ou thermocouples, d'un fluxmètre thermique selon un premier mode de réalisation de l'invention.

La figure 3 est une vue par-dessus, en plan, de la totalité d'un fluxmètre thermique selon l'invention.

La figure 4 est une vue analogue à celle de la figure 3, mais à plus grande échelle et limitée à une portion du fluxmètre, la couche supérieure de résine protectrice ayant été supprimée.

Les figures 5 et 6 représentent, respectivement en perspective cavalière avec arrachement partiel de la couche supérieure de résine protectrice et en coupe partielle (par VI-VI de la figure 5), une portion, comportant deux cellules élémentaires ou thermocouples, d'un fluxmètre thermique selon un second mode de réalisation de l'invention.

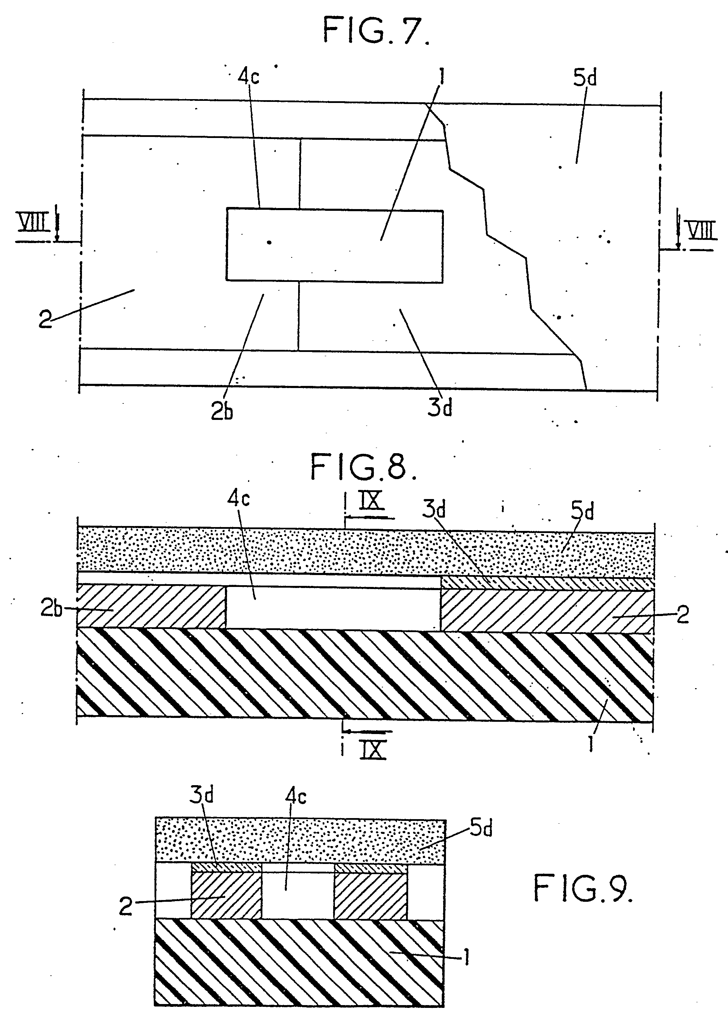

Les figures 7, 8 et 9 représentent, respectivement, une vue par dessus avec arrachement partiel de la couche supérieure protectrice, une vue en coupe par VIII-VIII de la figure 7 et une vue en coupe par IX-IX de la figure 8, d'une portion de fluxmètre thermique selon un troisième mode de réalisation de l'invention.

Référence étant d'abord faite aux figures 1 et 2 illustrant un premier mode de réalisation de l'invention, on y voit figurer deux cellules élémentaires ou thermocouples A et B disposés en série.

L'ensemble du fluxmètre thermique comprend dans ce mode de réalisation:

- une plaque, bande ou pellicule support 1 en matière plastique, par exemple en polyimide ou en verre époxy, formant substrat;

- une couche ininterrompue mince 2 en une première matière conductrice ou semi-conductrice, par exemple en constantan (à 35 à 50 % de nickel, le complément à 100 % étant du cuivre, et de préférence à 40 % de nickel et 60 % de cuivre, le constantan habituellement utilisé pour fabriquer des résistances électriques à 43 % de nickel convenant aussi très bien) ou en silicium dopé P;

- une série de dépôts très minces 3, obtenus de préférence par voie électrolytique, en une seconde matière conductrice ou semi-conductrice, par exemple en cuivre, fer, zinc, tellurure de bismuth, sulfure de plomb;

- une série de canaux ou trous 4 percés à la fois dans la première et dans la seconde matière au voisinage d'une extrémité (dans le sens de la longueur) de chaque dépôt très mince en la seconde matière, chaque canal 4 débouchant, dans ce mode de réalisation, à l'intérieur d'un dépôt 3;

- enfin, éventuellement, une couche supérieure 5 en une résine protectrice déposée par sérigraphie, telle une "épargne souple" utilisée en technologie des circuits imprimés.

Une disposition compacte fort avantageuse d'un grand nombre de cellules élémentaires ou thermocouples du type A, B des figures 1 et 2 est illustrée sur les figures 3 (d'ensemble) et 4 (partielle, mais à plus grande échelle).

Le support est alors constitué par une plaque la en matière plastique (polyimide ou résine époxy par exemple) de forme rectangulaire ou carrée sur laquelle on a collé une feuille de constantan d'épaisseur 25 micrometres qui a été ensuite attaquée par du perchlorure de fer le long de lignes parallèles 6 formant deux peignes imbriqués, par la technique classique de gravure utilisée pour la fabrication des circuits imprimés (on a déposé une couche protectrice en résine photosensible inerte vis-à-vis du perchlorure de fer sur l'ensemble de la feuille de constantan, puis on a éliminé cette couche suivant les lignes parallèles 6 avant de procéder à l'attaque par le perchlorure de fer qui n'a agi que le long de ces lignes).

On a ainsi obtenu une bande méandriforme 2a en constantan. Par exemple dans un carré de 130 mm de côté (a = 130 mm), on a logé une bande méandriforme 2a longue de 7250 mm.

Sur la bande méandriforme 2a on a déposé par voie électrolytique des couches 3a de cuivre épaisses de quelques micrometres et longues de 2,5 mm, l'espacement entre ces couches étant également de 2,5 mm par exemple (b = 2,5 mm, c = 2,5 mm). Le cuivrage a eu lieu après protection, au moyen d'une couche de résine photosensible, des portions ne devant pas être cuivrées.

Puis on a gravé des trous 4a ayant une section de 1,3 mm x 0,6 mm par attaque chimique.

Ces trous peuvent être revêtus intérieurement d'une couche 7 en la seconde matière conductrice ou semi-conductrice, notamment en cuivre.

Enfin on a recouvert la face supérieure (sur les parties cuivrées et non cuivrées) du dispositif au moyen d'une couche 5 (voir figures 1 et 2) d'une résine thermodurcissable protégeant le cuivre et le constantan de l'oxydation dont l'épaisseur et les caractéristiques thermiques sont choisies de façon à optimiser la sensibilité du capteur.

On a ainsi obtenu finalement un circuit méandriforme comportant 1250 cellules élémentaires ou thermocouples du type A, B connectés en série, une première borne étant en E (entrée) et une seconde borne en S (sortie) sur la figure 3.

La résistance de surface du dispositif selon les figures 1 à 4 est de 20 mΩ pour une feuille de constantan épaisse de 25 microns; pour une bande méandriforme de cette épaisseur longue de 7250 mm et large de 1,8 mm, la résistance électrique est de l'ordre de 80Ω. On notera que, malgré la présence des trous désignés par 4 sur les figures 1 et 2 et par 4a sur la figure 4, la bande de constantan est continue, ce qui assure la connexion en série des cellules élémentaires ou thermocouples tels que A et B.

Sur les figures 5 et 6 on a représenté un second mode de réalisation de l'invention.

Dans ce mode de réalisation, le premier support 5b est en polyimide avec un adhésif polymérisable à 150°C, la couche continue de première matière conductrice ou semi-conductrice (en constantan ou en silicium dopé P par exemple) étant dotée sur ses deux faces de dépôts 3b et 3c très minces de seconde matière conductrice ou semi-conductrice, telle que le cuivre, se chevauchant partiellement de part et d'autre de la couche 2. Dans ce cas également on prévoit des trous 4b traversant les deux dépôts 3b, 3c et la couche 2. Ces trous sont cuivrés intérieurement (couches 7b) pour assurer le contact électrique entre une paire de dépôts 3b et 3c se chevauchant partiellement. Enfin une couche 5c de résine, analogue à la couche 5 des figures 1 et 2, recouvre et protège la face inférieure de la couche 2 revêtue partiellement de dépôts de cuivre. On notera que, comme dans le premier mode de réalisation, la couche 2 en première matière conductrice ou semi-conductrice est continue malgré l'existence de trous 4b, ce qui assure la mise en série des cellules élémentaires ou thermocouples A' et B'.

Les propriétés thermiques du support adhésif et de la résine de protection sont différentes et sont choisies de façon à optimiser la sensibilité.

On peut disposer une série de cellules élémentaires A', B' suivant la configuration des figures 3 et 4, comme pour le premier mode de réalisation. L'ensemble du type illustré sur la figure 3 peut alors être disposé sur un support adhésif de faible épaisseur afin de réaliser un fluxmètre thermique de grande sensibilité. Par exemple un dispositif comprenait 1250 cellules A', B' sur une surface de 125 mm x 125 mm (a = 125), la largeur de la bande méandriforme de constantan étant de 1,8 mm et l'écart entre les portions parallèles de bande étant de 0,4 mm; les dépôts de cuivre avaient 2,1 mm de longueur (distance b sur la figure 4) et ils étaient séparés par des intervalles non cuivrés de 0,7 mm (distance c sur la figure 4). La sensibilité de ce dispositif était de l'ordre de 1,5 mV/W/dm2, avec les mêmes épaisseurs pour le constantan et le cuivre que dans le premier mode de réalisation.

La sensibilité augmente avec le nombre d'éléments. Or il est facile d'intégrer le dispositif selon l'invention. On a ainsi pu obtenir une sensibilité de l'ordre de 6 mV/W/dm2 avec des cellules élémentaires de plus petites dimensions.

Le fonctionnement d'un dispositif selon les figures 1 et 2 (premier mode de réalisation) est le suivant.

Si l'on applique une différence de température entre la face supérieure et la face inférieure du dispositif selon les figures 1 à 4, c'est-à-dire un flux thermique traversant de bas en haut ou de haut en bas (en considérant la figure 2) ce fluxmètre, on constate tout d'abord que, si le fluxmètre ne comportait pas les canaux ou trous 4, aucune différence de potentiel ne serait disponible entre les bornes E et S, car il n'y aurait aucun effet de dissymétrie permettant de créer une différence de température dans le plan horizontal (toujours en considérant la figure 2), différence de température horizontale qui permet le fonctionnement du thermocouple selon l'invention. Ce sont les trous ou canaux 4 qui réalisent une dissymétrie thermique car le flux thermique évite ces trous préférentiellement, étant donné que l'air est très mauvais conducteur, alors que les première et seconde matières conductrices ou éventuellement semiconductrices sont beaucoup plus conductrices de la chaleur que l'air. Il se crée alors une différence de température dans le plan horizontal entre les extrémités de gauche et de droite (en considérant les figures 1 et 2) de chaque zone 3, ce qui engendre une force électromotrice d'origine thermoélectrique aux extrémités de chaque cellule élémentaire ou thermocouple A, B; or ces thermocouples sont connectés en série par la bande 2 et on obtient finalement une différence de potentiel notable entre les bornes E et S grâce à la mise en série d'un très grand nombre de cellules élémentaires ou thermocouples.

Le même phénomène se produit dans le mode de réalisation des figures 5 et 6 (avec disposition dans le plan, comme illustré sur les figures 3 et 4), du fait du passage préférentiel du flux de chaleur par les canaux ou trous 4b lorsqu'une différence de température existe entre la face supérieure et la face inférieure du fluxmètre (en considérant la figure 6); en effet les canaux 4b créent une dissymétrie dans le plan horizontal du fait de leur position dissymétrique par rapport au centre des zones 3b et 3c, car la température entre les deux extrémités à gauche et à droite (en considérant les figures 5 et 6) des zones 3b et 3c engendre, dans chaque cellule élémentaire ou thermocouple A', B', une force électromotrice d'origine thermoélectrique. Les différentes cellules A', B' sont connectées en série par la bande 2 et on peut ainsi obtenir, avec les nombreuses cellules A', B' disposées comme illustré sur les figures 3 et 4, une force électromotrice totale importante.

Dans un troisième mode de réalisation illustré sur les figures 7 à 9, on prévoit - comme dans le premier mode de réalisation des figures 1 et 2 - des dépôts discrets très minces 3d, par exemple en cuivre, d'un seul côté de la couche continue mince 2, par exemple en constantan, déposée sur la plaque support 1, par exemple en "Kapton®". Mais, contrairement au premier mode de réalisation, les canaux ou trous 4c sont, dans le troisième mode de réalisation des figures 7 à 9, disposés pour déboucher à cheval sur une zone de dépôt 3d et une portion 2b non revêtue de dépôût de la couche mince 2. Enfin, comme dans le premier mode de réalisation, on peut prévoir une couche protectrice supérieure 5d, par exemple en "Mylar®".

Le mode de fonctionnement du dispositif des figures 7 à 9 est semblable à celui des figures 1 et 2, des cellules élémentaires selon les figures 7 à 9 pouvant être disposées comme illustré sur les figures 3 et 4.

Comme il va de soi et comme il résulte d'ailleurs déjà de ce qui précède, l'invention ne se limite nullement à ceux de ses modes d'application et de réalisation qui ont été plus spécialement envisagés; elle en embrasse, au contraire, toutes les variantes.

Par exemple on pourrait réaliser des cellules élémentaires ayant, comme dans le mode de réalisation des figures 5 et 6, des dépôts de chaque côté de la couche continue mince décalés de manière à ce que les canaux débouchent comme dans le mode de réalisation des figures 7 à 9 à cheval sur un dépôt et une portion non revêtue de dépôt de la couche continue, et ceci de chaque côté de la couche continue.

## Revendications

1. Fluxmètre thermique à nombreux thermocouples comportant une couche mince continue (2, 2a) une première matière conductrice ou semi-conductrice recouverte sur au moins une de ses faces par une succession de zones (3, 3a, 3b, 3c, 3d) séparées l'une de l'autre, constituées par des dépôts très minces d'une seconde matière conductrice ou semi-conductrice ayant un pouvoir thermoélectrique différent de celui de la première matière, caractérisé par le fait qu'au moins un canal (4, 4a, 4b, 4c) traverse de part en part au moins la plupart desdites zones et la couche mince sous-jacente, ces canaux étant décalés dans le même sens par rapport au centre de chaque zone traversée.

2. Fluxmètre thermique selon la revendication 1, caractérisé par le fait que lesdits canaux sont revêtus intérieurement d'un dépôt (7, 7b) de la seconde matière.

3. Fluxmètre thermique selon la revendication 1 ou 2, caractérisà par le fait que ladite couche mince continue a la forme d'une bande.

4. Fluxmètre thermique selon la revendication 3, caractérisé par le fait que la bande est méandriforme, en étant repliée pour former une structure rectangulaire ou carrée.

5. Fluxmètre thermique selon l'une quelconque des revendications précédentes, caractérisé par le fait que la couche mince (2, 2a) est déposée sur un substrat en matière isolante et elle est revêtue sur une seule face, à savoir celle opposée à face fixée sur le substrat, de zones de dépôt très minces (3, 3a, 3b, 3c, 3d).

6. Fluxmètre thermique selon l'une quelconque des revendications 1 à 4, caractérisé par le fait que la couche mince (2) est revêtue sur ses deux faces de zones de dépôt très minces (3b, 3c), les zones d'une des faces chevauchant partiellement les zones de l'autre face de part et d'autre de la couche mince et chaque canal (4b) que traverse tant la couche mince que les portions chevauchantes des deux dépôts très minces de part et d'autre de la couche mince, est décalé, par rapport au centre de chacun des deux dépôts, en sens inverses au-dessus et au-dessous de la couche.

7. Fluxmètre selon l'une quelconque des revendications précédentes, caractérisé en ce que chaque canal débouche à l'intérieur d'une zone de dépôt.

8. Fluxmètre selon l'une quelconque des revendications 1 à 6, caractérisé en ca que chaque canal (4c) débouche à cheval sur une zone de dépôt (3d) et une portion (2b) on revêtue de la couche mince.

9. Fluxmètre thermique selon l'une quelconque des revendications précédentes, caractérisé par le fait que la première matière est le constantan.

10. Fluxmètre thermique selon l'une quelconque des revendications précédentes, caractérisé par le fait que la seconde matière est le cuivre.

11. Fluxmètre thermique selon l'une quelconque des revendications précédentes, caractérisé par le fait que la succession de zones de dépôt très minces et la portion non revêtue de la couche mince ou de la ou des faces recouvertes sont revêtués d'une couche de résine protectrice (5, 5b, 5c, 5d).

12. Fluxmètre thermique selon l'une quelconque des revendications précédentes, caractérisé par le fait qu'il comprend plusieurs centaines de thermocouples élémentaires, à savoir autant qu'il y a de zones sur une face ou chacune des faces de la couche mince.

## Patentansprüche

1. Mit mehrehen Thermoelementen bestückter Wärmeflußlmesser, mit einer dünnen kontinuierlichen, aus eine ersten leitenden oder halbleitenden Material bestehenden Schicht ( 2, 2a), die auf zumindest einer ihher Seiten mit einer Reihe voneinander getrennter Zonen ( 3, 3a, 3b, 3c, 3d) bedeckt ist, die durch sehr dünne Ablagerungen eines zweiten leitenden oder halbleitenden Materials gebildet sind und eine thermoelektrische Leistung haben, die von jener des ersten Materials verschieden ist, dadurch gekennzeichnet, daß zumindest der größte Teil der Zonen und de darterliegende de Schicht von zumindest einem Kanal (4, 4a, 4b, 4c) durchsetzt werden, wobei diese Kanäle gegenüber der Mitte jeder durchsetzten Zone in der gleichen Richtung versetzt sind.

2. Wärmeflußmesser nach Anspruch 1, dadurch gekennzeichnet, daß die Kanäle in ihrem Inneren mit einer Ablagerung (7, 7b) des seiten Materials ausgekleidet sind.

3. Wärmeeflußlmesser nach Anspruch 1 oder 2, dadurch gekennzeichnet, daß die die kontinuierliche Schicht die Form eines Bandes hat.

4. Wärmeflußmesser nach Aspruch 3, dadurch gekennzeichnet, daß das Band Mäanderform hat und gefaltet ist, um eine rechteckige oder quadratische Struktur zu bilden.

5. Wärmeflußmesser nach einem der vorhergehenden Ansprüche, dadurch gekennzeichnet, daß die dünne Schicht ( 2, 2a) auf einem Substrat ( 1) aus Isoliermaterial abgelagert ist und auf nur einer Seite, nämlich auf jener Seite, die der am Substrat fixierten entgegengesetzt ist, mit den Zonen ( 3, 3a, 3b, 3c, 3d) aus der sehr dünnen Ablagerung bedeckt ist.

6. Wärmeflußmesser nach einem der Ansprüche 1 bis 4, dadurch gekennzeichnet, daß die dünne Schicht (2) auf beiden Seiten mit Zonen der sehr dünnen Ablagerung (3b, 3c) bedeckt ist, wobei die Zonen auf der einen Seite die Zonen auf der anderen Seite der dünnen Schicht teilweise überlappen, und jeder Kanal (4b), welcher sowohl die dünne Schicht als auch die einander überlappenden Teile der beiden sehr dünnen Ablagerungen auf beiden Seiten der dünnen Schicht durchsetzt, gegenüber der Mitte jeder der beiden Ablagerungen oberhalb und unterhalb der Schicht in der jeweils entgegengesetzten Richtung versetzt ist.

7. Wärmeflußmesser nach einem der vorhergehenden Ansprüche, dadurch gekennzeichnet, daß jeder Kanal im Inneren einer Ablagerungszone ausmündet.

8. Wärmeflußmesser nach einem der Ansprüche 1 bis 5, dadurch gekennzeichnet, daß jeder Kanal (4c) in einer Ablagerungszone (3d) und in einem nicht bedeckten Teil (2b) der dünnen Schicht ausmündet.

9. Wärmeflußmesser nach einem der vorhergehenden Asprüche, dadurch gekennzeichnet, daß das erste Material Konstantan ist.

10. Wärmeflußmesser nach einem der vorhergehenden Ansprüche, dadurch gekennzeichnet, daß das seite Material Kupfer ist.

11. Wärmeflunmesser nach einem·der vorhergehenden Ansprüche, dadurch gekennzeichnet, daß die Folge der Zonen der sehr dünnen Ablagerung und der nicht bedeckte Teil der dünnen Schicht oder der überdeckten Fläche(n) mit einer Schutzschicht aus Harz (5, 5b, 5c, 5d) überzogen sind.

12. Wärmeflußesser nach einem der vorhergehenden Ansprüche, dadurch gekennzeichnet, daß er mehrene Hurdert Elementar-Wärmelemente aufweist, entsprechend der auf einer oder jeder Seite der dünnen Schicht vorhandenen Zonen.

## Claims

1. Thermal fluxmeter having numerous thermocouples. comprising a continous thin coating (2, 2a) of a first conductor of semiconductor material covered over at least one of its faces by a succession of zones (3, 3a, 3b, 3c, 3d), separated from one another, constituted by very thin deposits of a second conductor or semiconductor material having a thermoelectric power different from that of the first material, characterised in that at least one passage (4, 4a, 4b, 4c) traverses from one side to the other at least the majority of the said zones and the subjacent thin coating, said passages being offset in the same direction in relation to the centre of each zone traversed.

2. Thermal fluxmeter according to Claim 1, characterised in that the said passages are coated on the inside with a deposit (7, 7b) of the second material.

3. Thermal fluxmeter according to Claim 1 or 2, characterised in that the said continuous thin coating takes the form of a strip.

4. Thermal fluxmeter according to Claim 3, characterised in that the strip is of meandering form, being bent back to form a rectangular or square structure.

5. Thermal fluxmeter according to any one of the preceding Claims, characterised in that the thin coating (2, 2a) is deposited on a substrate (1) of insulating material and it is covered on one face only, in other words that opposite the side which is fixed on the substrate, with zones of very thin deposits (3, 3a, 3b. 3c, 3d).

6. Thermal fluxmeter according to any one of Claims 1 to 4, characterised in that the thin coating (2) is covered on both faces with zones of very thin deposit (3b, 3c), the zones on one of the faces partially straddling the zones on the other face on either side of the thin coating and each passage (4b) which traverses both the thin coating and also the straddling portions of the two very thin deposits on either side of the thin coeting is offset in reletion to the centre of each of the two deposits, in opposite directions above and below the coating.

7. Fluxmeter according to any one of the preceding Claims, characterised in that each passage opens out onto the inside of a deposit zone.

8. Fluxmeter according to any one of Claims 1 to 6, characterised in that each passage (4c) opens out astride a deposit zone (3d) and a non-covered portion (2b) of the thin coating.

9. Thermal fluxmeter according to any one of the preceding Claims, characterised in that the first material is constantan.

10. Thermal fluxmeter according to any one of the preceding Claims, characterised in that the second material is copper.

11. Thermal fluxmeter according to any one of the preceding Claims, characterised in that the succession of zones of very thin deposits and the non-covered portion of the thin coating or of the covered face or faces are covered with a coating of protective resin (5, 5b, 5c, 5d).

12. Thermal fluxmeter according to any one of the preceding Claims, characterised in that it comprises several hundreds of elementary thermocouples, in other words as many as there are zones on a face or on each of the faces of the thin coating.

Four sheets of drawings

# FIG.1.

# FIG.2.

# FIG.3.

# FIG.4.

# FIG. 5.

# FIG. 6.

# FIG.7.

# FIG.8.

# FIG.9.